# EUROPÄISCHE PATENTSCHRIFT

(11) **EP 0 704 108 B1**
(45) Veröffentlichungstag und Bekanntmachung des Hinweises auf die Patenterteilung: **09.07.2003**
(21) Anmeldenummer: 95914351.2
(22) Anmeldetag: 08.04.1995
(51) Int. Cl.: H01L 29/872

(54) **METALL-HALBLEITER-DIODE UND VERFAHREN ZUR HERSTELLUNG VON METALL-HALBLEITER-DIODEN**
METAL-SEMICONDUCTOR DIODE AND METHODS FOR PRODUCING METAL SEMICONDUCTOR DIODES
DIODE A CONTACT METAL-SEMICONDUCTEUR ET SES PROCEDES DE PRODUCTION

(30) Priorität: 14.04.1994 DE 4412475
(43) Veröffentlichungstag der Anmeldung: 03.04.1996
(73) Patentinhaber: United Monolithic Semiconductors GmbH, 89081 Ulm (DE)
(72) Erfinder: BRUGGER, Hans, D-89250 Senden (DE)
(74) Vertreter: Weber, Gerhard, Dipl.-Phys.
(86) Internationale Anmeldenummer: EP9501300
(87) Internationale Veröffentlichungsnummer: WO95028743

(56) Entgegenhaltungen:
- FR-A- 2 154 538
- PATENT ABSTRACTS OF JAPAN vol. 12 no. 246 (E-632) ,12.Juli 1988 & JP,A,63 036578 (SUMITOMO ELECTRIC IND LTD) 17.Februar 1988,
- ELECTRONICS LETTERS, Bd. 26, Nr. 3, 1.Februar 1991 STEVENAGE GB, Seite 190/191 WANG G W ET AL 'SUBMICRON-GATE ION-IMPLANTED IN0.15GA0.85AS/GAAS MESFETS WITH GRADED INDIUM COMPOSITION'
- IEEE TRANSACTIONS ON MICROWAVE THEORY AND TECHNIQUES, Bd. 39, Nr. 1, Januar 1991 NEW YORK US, Seiten 1-5, D.G. GARFIELD ET AL. 'RF performance of a novel planar millimeter-wave diode incorporating an etched surface channel' in der Anmeldung erwähnt

## Beschreibung

In Sensor-, Kommunikations-, und Radarsystemen im Anwendungsbereich der Millimeterwellenfrequenzen werden im allgemeinen gleichrichtende, majoritätsträgerbestimmte Metall-Halbleiter-Dioden (sog. Schottky-Dioden) in Form von Einzelbauelementen oder in Form von monolithisch integrierten Schaltungen (sog. MMICs) für Mischer und Detektoren eingesetzt. Es kommen nahezu ausschließlich Metall-Halbleiter-Dioden aus dem III/V-Material Galliumarsenid (GaAs) zum Einsatz, bedingt durch die für diese Anwendungszwecke günstigeren elektronischen Eigenschaften. Ferner ist das resistive (sog. halbisolierende) GaAs-Substrat aus fertigungstechnischen

Gründen für die Integrationstechnik im Hochfrequenzbereich (HF) günstig und wird deswegen bevorzugt eingesetzt.

Mit derartigen Dioden werden die bisher höchsten Empfindlichkeiten realisiert und maximale Frequenzen bis in den Terahertzbereich erreicht. Nachteilig an diesen Bauelementen ist die relativ hohe Einsatzspannung der Dioden in Flußrichtung, die, bedingt durch elektronische Oberflächenzustände im GaAs, typischerweise im Bereich zwischen 0,7 V und 0,8 V liegt. Um eine ausreichende Leistungsfähigkeit für Mischeranwendungen hinsichtlich Konversionsverlust, Pumpleistung, Empfindlichkeit und Rauschverhalten zu erreichen, werden derartige Dioden daher mit Vorspannungen betrieben (z.B. S.A. Maas: "Microwave Mixers", 2nd edition, Artec House, Boston, 1993).

Der Betrieb mit einer Vorspannung führt allerdings zu als Vorstrombrumm bekannten Störungen. Andererseits erfordert ein Betrieb ohne Vorspannung eine hohe Pumpleistung des Lokaloszillators (LO) zur Erreichung eines niedrigen Konversionsverlusts.

Es ist von theoretischen Berechnungen aus U.V. Bhapkar, T.A. Brennan and R.J. Mattauch: "InGaAs Schottky Barrier Mixer Diodes for Minimum Conversion Loss and Low LO Power Requirements at Terahertz Frequencies", Proceedings of the 2nd International Symposium on Space Terahertz Technology, February 1991, pp. 371 - 388, bekannt, daß Schottky-Dioden mit reduzierten Elektronenaustrittsbarrieren an InGaAs-Verarmungszonenschichten im Vergleich zu GaAs-Verarmungszonenschichten eine deutliche Reduzierung der erforderlichen LO-Leistung zum Pumpen der Mischerdiode bei ähnlichen Konversionsverlusten erwarten lassen. Außerdem sind in der genannten Veröffentlichung bereits Strukturen aus InGaAs-Schichten mit konstantem In-Gehalt (20% bzw. 30%) und experimentelle Ergebnisse erwähnt. Zur Erreichung akzeptabler Verarmungszonenlängen wurden dabei Schichtdicken zwischen 80 nm und 150 nm realisiert. Diese Dicken sind jedoch weit über den jeweiligen, kritischen Schichtdicken, so daß die Bereiche bereits partiell relaxiert sind. Derartige Strukturen enthalten eine hohe Anzahl von Versetzungslinien und Kristalldefekten, die sich sehr negativ auf das elektronische Verhalten der Diode, sowie auf die Zuverlässigkeit und die Qualität des Bauelements auswirken.

Die Realisierung von nicht relaxierten InGaAs-Schichten auf GaAs mit hohem In-Gehalt ist zwar prinzipiell durch eine drastische Reduzierung der InGaAs-Schichtdicke auf Werte deutlich unterhalb der kritischen Schichtdicke erreichbar (z.B. einer Dicke von weniger als 5 nm für eine In-Konzentration von 30%), jedoch führt dies zu keiner nennenswerten Elektronenbarrierenerniedrigung mehr, da der Leitungsbandsprung zwischen InGaAs und GaAs sehr nahe am Schottky-Kontakt ist und die Leitungsbandkante des GaAs-Materials die effektive Barriere höhe für den Stromtransport darstellt. Eine derartiges Bauelement verhält sich also ähnlich wie eine Diode mit einer GaAs-Verarmungszonenschicht.

Aus K. Kajiyama, Y. Mizushima, and S. Sakata: "Schottky Barrier Height of n-InxGal-xAs Diodes", Applied Physics Letters, vol 23, no. 8, pp. 458 - 459, 1973, ist bekannt, daß die Elektronenaustrittsbarriere in InGaAs-Material, ausgehend von reinem GaAs-Material, mit zunehmendem In-Gehalt kontinuierlich abnimmt und für reines InAs-Material keine Barriere mehr existiert. Allgemein bekannt ist, daß sich die Gitterkonstante nahezu linear mit zunehmendem In-Gehalt vergrößert, was zu einer entsprechenden Fehlanpassung zwischen InGaAs und GaAs führt. An der Grenzfläche von gitterangepaßtem und verspanntem (Kompression) InGaAs und GaAs bilden sich elektronische Bandsprünge aus derart, daß das Leitungsband in InGaAs niedriger und das Valenzband höher liegt als in GaAs. Ferner ist bekannt, daß sich die Bandlückenenergie von elastisch verspanntem InGaAs auf GaAs nichtlinear mit zunehmendem In-Gehalt verringert.

Weitere kritische Parameter solcher Dioden insbesondere in Mischeranordnungen sind die sogenannte cut-off-Frequenz (fco), der Idealitätsfaktor (n) und die Rauschzahl des Bauelements. Diese Größen hängen maßgeblich von der nichtlinearen Leitfähigkeit und den limitierenden, verlustbehafteten Ersatzschaltbildgrößen Serienwiderstand (Rs), Sperrschichtkapazität (Cj0) und parasitäre Streukapazität (Cpar) ab, die es insgesamt zu minimieren gilt, wobei die Beziehung gilt fco=[2πRs*(Cj0+Cpar)]⁻¹.

Eine Anordnung und ein Verfahren zur Herstellung von planaren Millimeterwellen-Dioden ist aus D.G. Garfield, R.J. Mattauch, und S. Weinreb: "RF Performance of a Novel Planar Millimeter-Wave Diode Incorporating an Etched Surface Channel", IEEE Transactions on Microwave Theory and Techniques, vol. 39, No. 1, pp. 1 - 5, 1991, bekannt. Die Struktur basiert auf einer GaAs-Materialschichtenfolge mit relativ dicken epitaktischen Schichten. Zur Reduzierung der parasitären Kapazitäten verwenden die Autoren eine geätzte Grabenstruktur und eine Luftbrückenzuleitung für die Schottky-Metallisierung. Damit lassen sich gute Cjo- und Rs-Werte erreichen, jedoch sind die Verfahrensschritte technologisch aufwendig und die Struktur hat außerdem den Nachteil, daß die parasitäre Koppelkapazität als dominanter Anteil in Cpar zwischen der Schottky-Metallisierungssleitung und den, über eine dielektrische Schicht getrennten, leitfähigen Halbleiterschichten groß ist. Die Anordnung ist auch nicht geeignet für die Herstellung von planaren Bauelementen.

Eine Anordnung und ein Verfahren zur Herstellung von planaren Schottky-Mischerdioden ist aus B. Adelseck, A. Colquhoun, J.-M. Dieudonne, G. Ebert, D.-E. Schmegner, W. Schwab, and J. Selders: "A monolithic 60 GHz Diode Mixer and IF Amplifier in Compatible Technology", IEEE Transactions and Microwave Theory and Techniques, vol 37, pp. 2142 - 2147, 1989, bekannt. Dabei erfolgt die Herstellung des Bauelements mit einer MESFET-Technologie durch Einsatz folgender Verfahrensschritte: Silizium-Implantation, Hochtemperaturausheilung, epitaktisches Überwachsen, Isolations-Implantation, Elektronenstrahllithographie. Der Schottky-Metallkontakt ist dabei über einen "Recess"-Graben auf die Verarmungszonenschicht abgesenkt, die sich vergraben unterhalb einer hochdotierten Kontaktschicht befindet. Es wurden veröffentlichte Grenzfrequenzen von fco < 1,5 THz und Einsatzspannungen zwischen 0,7 V - 0,8 V erreicht (J.M. Dieudonne, B. Adelseck, E.E. Schmegner, R. Rittmeyer, and A. Colquhoun: "Technology Related Design of Monolithic Millimeter-Wave Schottky Diode Mixers", IEEE Transactions and Microwave Theory and Techniques, vol 40, pp. 1466 - 1474, 1992). Bei diesem Verfahren lassen sich keine Dioden mit reduzierten Einsatzspannungen realisieren und keine sehr niedrigen Rs-Werte bei gleichzeitig sehr kleinen cjo-Werten erreichen, da die durch eine Silizium-Implantation hergestellte, ohmsche Zuleitungsschicht in ihrer Leitfähigkeit begrenzt ist, der Stromfluß durch die niedrig dotierte Verarmungszonenschicht zu erfolgen hat (FET-Anordnung)und der Schottky-Metallkontaktwiderstand bei diesen kleinen Strukturgeometrien (< 0,3 µm) bereits deutlich ansteigt und dominierend Rs bestimmt.

In "Electronic Letters Bd.26 Nr.3 (1990), S. 190-191" ist ein In Ga As / Ga As-MESFET mit einem auf der In Ga As-Schicht aufgebrachten Schottky-Kontakt beschrieben. Der In-Gehalt in der In Ga As-Schicht nimmt dabei vom Heteroübergang zur Oberfläche, d.h. in Richtung Schottky-Kontakt ab.

Aufgabe der vorliegenden Erfindung ist es, eine Metall-Halbleiter-Diode, die vorteilhafte Eigenschaften insbesondere für den Betrieb in Hochfrequenz-Mischeranordnungen aufweist, sowie ein einfaches und kostengünstiges Verfahren zur Herstellung von Metall-Halbleiter-Dioden anzugeben.

Die erfindungsgemäße Metall-Halbleiter-Diode ist in Anspruch 1, das Verfahren zur Herstellung der Metall-Halbleiter-Diode ist in Anspruch 6 beschrieben. Die Unteransprüche enthalten vorteilhafte Ausführungen und Weiterbildungen der Erfindung.

Die erfindungsgemäße Metall-Halbleiter-Diode ist planar und monolithisch integrierbar. Sie weist eine im Vergleich zu Dioden mit einer GaAs-Verarmungszonenschicht in Flußrichtung reduzierte Einsatzspannung auf. Dies erlaubt den Betrieb in Mischeranordnungen ohne Vorspannung mit deutlich reduzierter Oszillatorleistung. Darüber hinaus ergibt sich durch die Verspannung der Verarmungszonenschicht eine günstigere Durchbruchspannungscharakteristik in Sperrichtung.

Wichtig dabei ist, daß innerhalb der InGaAs-Verarmungszonenschicht die Indiumkonzentration, ausgehend von der hochdotierten, ohmschen Zuleitungsschicht in Richtung der Epitaxieoberfläche zum Schottky-Metallkontakt hin, kontinuierlich, vorzugsweise entsprechend einer Funktion höherer Ordnung ansteigt und die Schicht insgesamt elastisch verspannt ist. Besonders vorteilhaft dabei ist, daß die Herstellung der gesamten vertikalen Schichtstruktur in einem zusammenhängenden Prozeßschritt mittels eines Epitaxieverfahrens erfolgen kann.

Vorteilhaft ist ferner, daß durch die Anordnung des Schottky-Metall-Kontakts auf der Epitaxieoberfläche eine planare Bauelementstruktur mit besonders günstigen Eigenschaften erzeugt wird. Die Eigenschaften einer derartigen Diode werden weiter dadurch vorteilhaft beeinflußt, daß das Verarmungszonengebiet innerhalb einer flachen Mesastruktur liegt und der ohmsche Metallkontakt auf der, unter der Verarmungszonenschicht liegenden, hochdotierten Zuleitungsschicht abgesenkt ist. Dadurch lassen sich gleichzeitig niedrige Serienwiderstände und niedrige Kapazitäten in den Dioden realisieren. Außerhalb des Bauelementbereichs laufen die Metallisierungsbahnen für die Anoden- und Kathoden-Anschlüße auf der Halbleiteroberfläche, wobei die urspünglich leitfähigen Epitaxieschichten außerhalb des Bauelements durch eine selektive Implantation isoliert werden.

Das in Anspruch 6 beschriebene erfindungsgemäße Verfahren zeichnet sich insbesondere dadurch aus, daß es ermöglicht, durch den Einsatz von nur
- einem Epitaxieschritt zur Schichtabscheidung
- einem Implantationsschritt zur Isolation des außerhalb des Bauelements liegenden Gebiete und
- unter Einsatz einer konventionellen, optischen Kontaktlithographietechnik zur Strukturierung (Photolithographie, Steppertechnologie) vertikal gechichtete Dioden herzustellen.

Damit lassen sich Strukturdimensionen von Schottky-Metallkontakten im Bereich von 0,5 µm und 1 µm technologisch einfach realisieren und planare Metall-Halbleiter-Dioden mit fco-Werten zwischen 2 THz und 3 THz mit gleichzeitig reduzierten Einsatzspannungen herstellen. So werden beispielsweise technologisch aufwendige Verfahrensschritte, wie Luftbrückentechniken, Grabenätz- und "Recess"-Prozeße, epitaktische Überwachstumsschritte, Hochtemperaturausheilprozeße und Elektronenstrahlbelichtungstechniken vermieden.

Besonders vorteilhaft ist die Kombination der Merkmale der Verarmungzonenschicht mit ansteigendem Indium-Gehalt und der planaren Struktur mit umgebenden Isolationsgebieten und an der Oberfläche liegendem Schottky-Metall-Kontakt bzw. der damit verbundenen Herstellungsverfahren.

Die vorgeschlagenen Metall-Halbleiter-Dioden und die Verfahren zu deren Herstellung bringen insbesondere folgende Vorteile:
- Einfaches und kostengünstiges, technologisches Bauelementherstellungsverfahren
- Reduzierung der parasitären Größen
- Geringe Elektronenaustrittsbarriere und reduzierte Einsatzspannung in Flußrichtung (hohe In-Konzentration am Metallkontakt)
- Verbesserung des Idealitäts-Faktors der Diode
- hohe kritische Schichtdicke der InGaAs-Verarmungszonenschicht
- Niedriger Serienwiderstand (hohe Ladungsträgerbeweglichkeit und keine abrupte Hetero-Grenzfläche in der Verarmungszone, hoch leitende Zuleitungsschichten)
- große biaxiale Verspannung im Bereich hohen elektrischen Feldes mit günstigerer Durchbruchspannungscharakteristik in Sperrichtung (Reduzierung der Stoßionisationsrate)
- isolierende Gebiete außerhalb des Bauelementbereichs, damit planare Anordnungen realisierbar und monolithische Integration von zusätzlichen Bauelementen durch Hetero-Epitaxie bzw. epitaktisches Überwachsen möglich, z.B. von MESFET, HFET, LO, HF-leistungserzeugende Bauelemente, etc.

Die Erfindung ist nachfolgend anhand von Ausführungsbeispielen unter Bezugnahme auf die Abbildungen noch eingehend veranschaulicht.

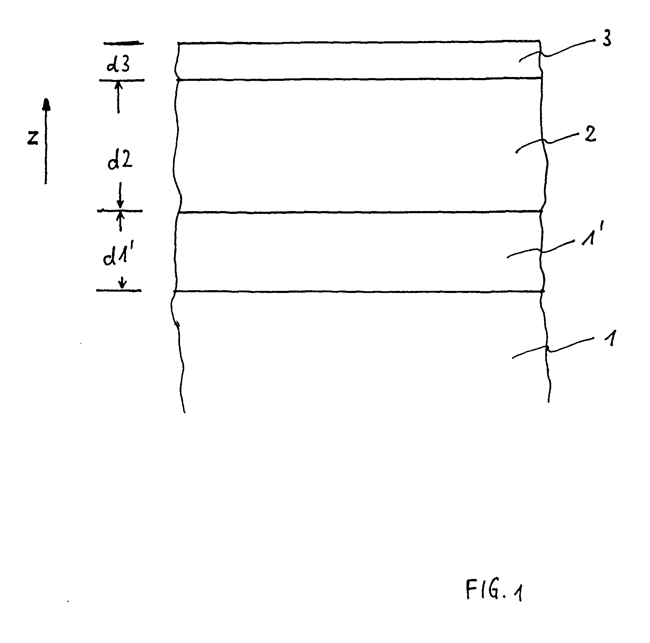

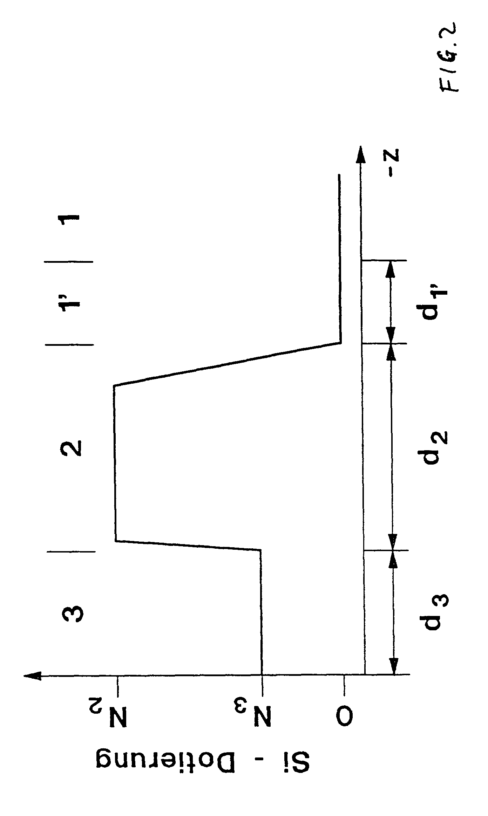

In FIG. 1 und FIG. 2 sind der vertikale Schichtaufbau und das Dotierstoffprofil in z-Richtung (senkrecht zu den Ebenen der Epitaxieschichten) schematisch dargestellt. Als Substrat wird eine undotierte, halbisolierende GaAs-Scheibe 1 verwendet. Mit Hilfe einer Epitaxiemethode, vorzugsweise Molekularstrahlepitaxie, werden die einzelnen Halbleiterschichten 1', 2 und 3 in einem Prozeßschritt nacheinander abgeschieden:
- Eine undotierte Pufferschicht 1', vorzugsweise aus GaAs-Material und einer AlGaAs/GaAs-Übergitterstruktur mit einer beispielhaften Gesamtdicke d1' im Bereich zwischen 0,1 µm und 0,5 µm
- Eine hochdotierte ohmsche n++-Zuleitungsschicht 2 aus GaAs-Material, vorzugsweise mit einer Dicke d2 im Bereich zwischen 0,4 µm und 0,8 µm und einer Dotierstoffkonzentration N2 zwischen 5x10¹⁸cm⁻³ und 1x10¹⁹cm⁻³, vorzugsweise mit Silizium, zur Realisierung einer niederohmigen Schicht mit einem Schichtwiderstand von typischerweise weniger als 10 Ω/sq
- Eine schwach dotierte und indiumhaltige InₓGa₁₋ₓAs Verarmungszonenschicht 3, vorzugsweise mit einer Dicke d3 im Bereich zwischen 50 nm und 100 nm und einer konstanten Dotierstoffkonzentration N3 im Bereich zwischen 10¹⁶cm⁻³ und 10¹⁷cm⁻³, vorzugsweise mit Silizium. Eine alternative vorteilhafte Ausführungsform sieht anstelle einer konstanten Dotierstoffkonzentration N3 ein innerhalb der Verarmungszonenschicht 3 über die Dicke d3 zum Metall-Kontakt hin kontinuierlich abfallendes oder kontinuierlich ansteigendes Dotierstoffprofil, beispielsweise ausgehend von 10¹⁷cm-³ bis 10¹⁶cm-³ an der Epitaxieoberfläche, vor.

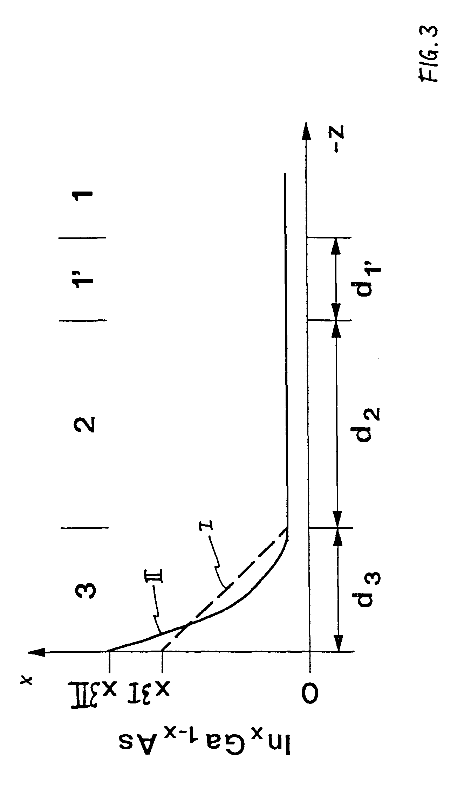

In der vorgeschlagenen, vorteilhaften Anordnung wird das Konzentrationsprofil der indiumhaltigen InₓGa₁₋ₓAs Verarmungszonenschicht 3 vorzugsweise so gewählt, daß die In-Konzentration x innerhalb der Verarmungszonenschicht 3 kontinuierlich ansteigt, d.h. eine Funktion der Ortskoordinate z ist (x = f(z)). Das In-Konzentrationsprofil von zwei beispielhaften Schichtstrukturen ist in FIG. 3 dargestellt. Die mit unterbrochener Linie gezeichnete Kurve I zeigt ein linear ansteigendes In-Profil mit einem maximalen In-Anteil x3=x3I an der Epitaxieoberfläche. Die durchgezogene Kurve II zeigt ein Beispiel für ein bevorzugterweise nichtlineares, dem Verlauf einer Funktion höherer Ordnung folgendes In-Profil mit einer in Richtung Oberfläche z.B. quadratisch zunehmenden In-Konzentration. Die maximal einstellbare, kritische In-Konzentration x3=x3II an der Oberfläche kann in diesem Fall deutlich größer gewählt werden als x3I beim linearen Profil oder als bei einem konstanten Profil (x = const.). Dadurch lassen sich deutlich reduzierte Einsatzspannungen und günstigere Bahnwiderstände erreichen.

Vorzugsweise setzt der In-Gehalt x in der Schicht 3 bei x=0 beginnend ein. Durch den allmählichen und kontinuierlich ansteigenden In-Gehalt wird nicht nur ein vorteilhafter Verlauf der Verspannung in der Schicht 3 erreicht, sondern es wird auch noch eine bei einer abrupten Hetero-Grenzfläche GaAs/InGaAs auftretende additive und für das Bauelement nachteilige Widerstandskomponente im Stromtransport vermieden.

Die kritische Schichtdicke der elastisch verspannten Verarmungszonenschicht 3 ist dann erreicht, wenn die durch die biaxiale Kompression gespeicherte, elastische Energie einen kritischen Wert überschreitet, nämlich die Schwellenergie, ab der der Kristall durch Bildung von Versetzungslinien relaxiert. Diese Schwellenergie ist im wesentlichen proportional zum Quadrat der Verspannung und linear von der Schichtdicke d3 abhängig, wobei die elastische Verspannung definiert ist über den Unterschied der Gitterkonstanten der InGaAs-Schicht und dem GaAs-Substrat.

Dabei kann in guter Näherung angenommen werden, daß die Gitterkonstante von InGaAs linear mit steigendem In-Gehalt zunimmt. In allgemein bekannter Weise kann abgeschätzt werden, wie dick die elastisch verspannte InGaAs-Verarmungszonenschicht für unterschiedliche In-Konzentrationsprofile x(z) maximal werden kann, bevor der Kristall relaxiert und wie hoch folglich die maximale In-Konzentration an der Epitaxieoberfläche, bestimmend für die Bildung der Elektronenaustrittsbarriere und somit Einsatzspannung der Metall-Halbleiter-Diode, ausgelegt werden kann.

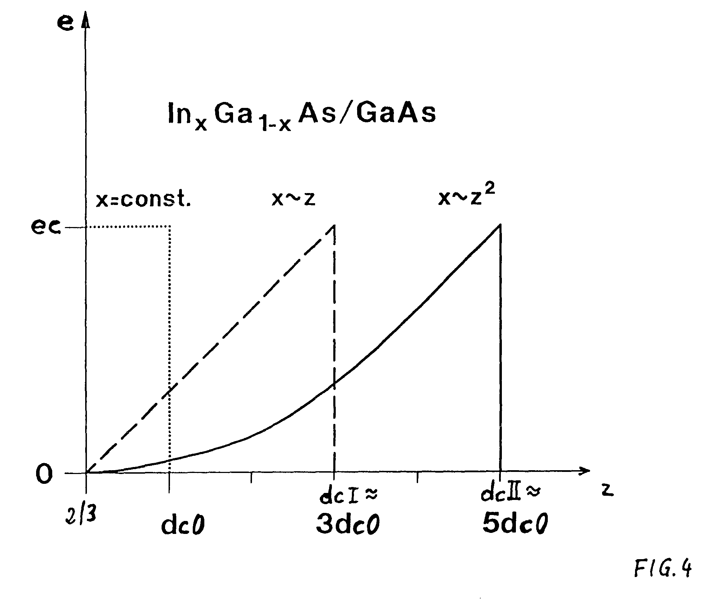

In FIG. 4 sind beispielhaft Verspannungsprofile für konstanten, linear ansteigenden und quadratisch ansteigenden Indium-Gehalt x(z) als Verspannung e(z) und deren maximale Schichtdicken dc dargestellt. Ausgehend von einer gewünschten, maximalen In-Konzentration x3 an der Epitaxieoberfläche, was einem Verspannungswert ec entspricht, läßt sich für verschiedene In-Profile die jeweils maximale Schichtdicke für die Verarmungszonenschicht ableiten. Es ergibt sich, daß man, ausgehend von einer kritischen Schichtdicke dc0 für ein konstantes Profil (x = const.), bei linear ansteigendem In-Gehalt ungefähr die dreifache Schichtdicke dcI=3dc0 und für ein bevorzugtes In-Profil mit quadratischer Ortsabhängigkeit die fünffache Schichtdicke dcII=5dc0 realisieren kann.

Durch die ortsabhängige, in Richtung der Oberfläche zunehmende In-Konzentration wird eine deutlich dickere, elastisch verspannte Schicht mit einer hohen In-Konzentration an der Oberfläche erreicht, unter Vermeidung eines Leitungsbandsprungs nahe der Epitaxieoberfläche. Dadurch kann die Elektronenaustrittsbarriere und somit die Diodeneinsatzspannung deutlich abgesenkt werden und gleichzeitig wird ein abrupter Heterostrukturgrenzübergang von GaAs zu InGaAs nahe der Oberfläche vermieden und die Elektronenbeweglichkeit ist innerhalb der Verarmungszonenschicht höher als in GaAs. Dies wirkt sich sehr vorteilhaft auf den Bahnwiderstand, welcher eine Komponente zum Diodenserienwiderstand bildet, aus. Dieser Vorteil kann auch dazu benutzt werden, die Dotierkonzentration N3 in der Verarmungszonenschicht 3 weiter zu erniedrigen oder ein ortsabhängiges Dotierprofil anstelle einer konstanten Dotierkonzentration, einzubauen, was sich, je nach Anwendungsfall, vorteilhaft auf das Bauelementverhalten auswirken kann, z.B. Realisierung einer MOTT-Diode mit einer schwachen Abhängigkeit der Sperrschichtkapazität vom Arbeitspunkt. In der nachfolgenden Tabelle sind die für die Einsatzspannungserniedrigung maßgebenden, maximalen In-Konzentrationen x3 an der Epitaxieoberfläche zum Schottky-Metallkontakt für eine beispielhafte Verarmungszonenschichtdicke d3 von 80 nm für die unterschiedlichen In-Profile aufgelistet. Man erkennt, daß sich mit einer vorteilhaften, quadratischen In-Konzentrationsabhängigkeit eine mehr als doppelt so hohe In-Konzentration und somit eine deutlich reduzierte Einsatzspannung realisieren läßt. Für einen In-Konzentrationsverlauf nach einer Funktion noch höheren Grades läßt sich dieser Effekt noch verstärken.

| In-Konzentrationprofil | max. In-Gehalt x3 (%) |
|---|---|
| konstant, x = const | 10,0 |
| linear, x ∼ z | 17,3 |
| quadratisch, x∼z² | 22,4 |

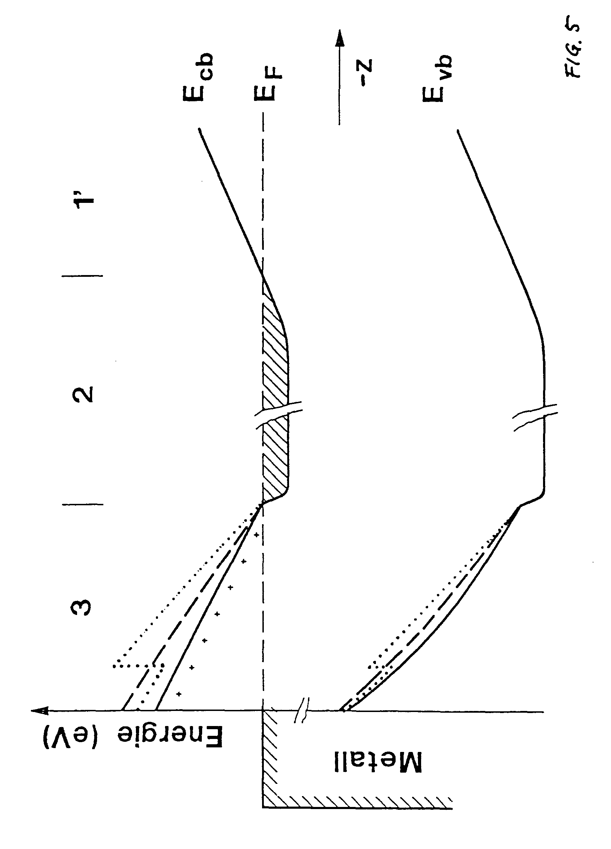

In FIG. 5 ist schematisch der Verlauf des elektronischen Leitungsbandes (Ecb) und des Valenzbandes (Evb) ohne angelegte, äußere Spannung (Fermi-Energie EF = const.) innerhalb der Metall-Halbleiter-Diodenstruktur in z-Richtung dargestellt, beispielhaft für ein konstantes In-Profil, ein lineares In-Profil und ein quadratisches In-Profil jeweils in dem FIG. 4 entsprechenden Linientyp. Vorteilhafterweise wird die Dotierkonzentration N3 dabei so klein gewählt, daß die sich ausbildende Verarmungszone bereits bis an die hochdotierte, ohmsche Zuleitungsschicht 2 reicht (sog. MOTT-Design), was sich neben der Einsatzspannungserniedrigugng ebenfalls vorteilhaft auf die erforderliche LO-Leistungsbilanz auswirkt. Man erkennt aus FIG. 5 auch, daß sich bei Verwendung einer einfachen InGaAs-Schicht mit konstantem In-Gehalt nahe der Oberfläche ein Leitungsbandsprung ausbildet, der die effektive Elektronenbarrierenerniedrigung durch InGaAs überwiegend kompensiert und sich auch negativ auf den Serienwiderstand auswirkt. Aufgrund des nichtlinearen Zusammenhangs der Energielücke vom In-Gehalt, zeigen die Valenzbänder eine ausgeprägtere Bandverbiegung.

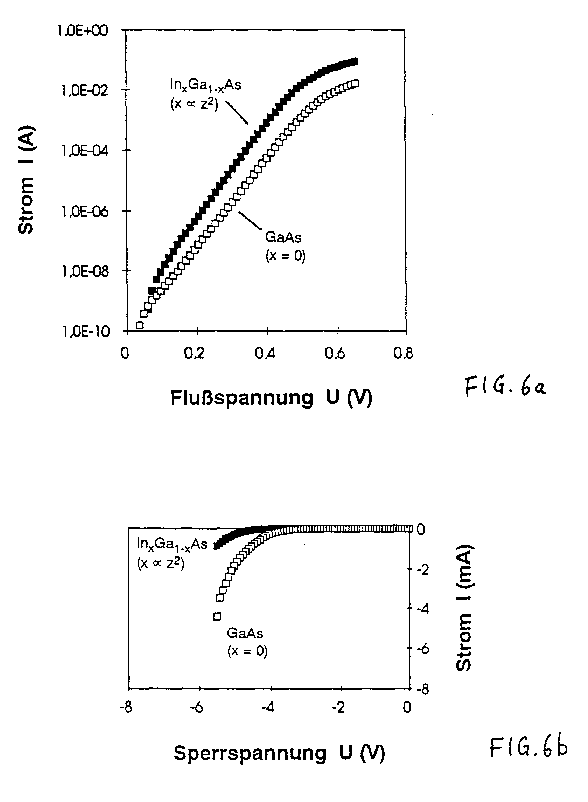

FIG. 6a zeigt die gemessene Strom/Spannungscharakteristik einer großflächigen Metall-Halbleiter-Diode (2000 µm²) mit einer InGaAs-Verarmungszonenschicht der Dicke d3 = 100 nm und einer Dotierung N3 = 1x10¹⁷cm⁻³. Das In-Konzentrationsprofil ist entsprechend der vorteilhaften Ausführung nach einer nominell quadratischen Ortsabhängigkeit ausgelegt. Die maximale In-Konzentration an der Epitaxieoberfläche ist x3II = 20 % Die Meßpunkte sind durch ausgefüllte Quadrate dargestellt. Zum Vergleich ist eine entsprechende Referenzprobe mit einer GaAs-Verarmungszonenschicht mit einer Dotierung von N3 = 3x10¹⁷cm⁻³ durch offene Quadrate dargestellt. Die Metall-Halbleiter-Diode mit InGaAs-Kompositionsprofil zeigt über einen weiten Spannungsbereich deutlich höhere Stromwerte und die Steigung der Strom/Spannungskurve, die ein Maß für den Idealitätsfaktor n ist, verläuft über einen weiten Strombereich steiler als bei der Referenzdiode mit GaAs-Verarmungszonenschicht. Der gemessene Wert von n = 1,04 ist deutlich geringer als bei der Referenzprobe mit n = 1,15. Insbesondere im Bereich U>0,5 V beginnt die Diode durchzusteuern und die I(U)-Kurve flacht aufgrund des endlichen Serienwiderstands ab. Im Flußbereich werden hohe Stromwerte ( 15 mA) bereits bei um ca 0,2 V geringeren Spannungswerten erreicht als bei der Referenzdiode. Diese verbesserten Transporteigenschaften der vorgeschlagenen Bauelementanordnung sind eine Folge des speziellen In-Konzentrationsprofils. Weiterhin ist es in derartigen Diodenanordnungen vorteilhaft, daß sich durch die verbesserten elektronischen Eigenschaften (insb. Bahnwiderstand) die Dotierkonzentration in der Verarmungszonenschicht N3, weiter abgesenkt werden kann, was sich auch in einer verbesserten Durchbruchscharakteristik in Sperrichtung zeigt. Dies ist in FIG. 6b anhand der Meßkurven dargestellt.

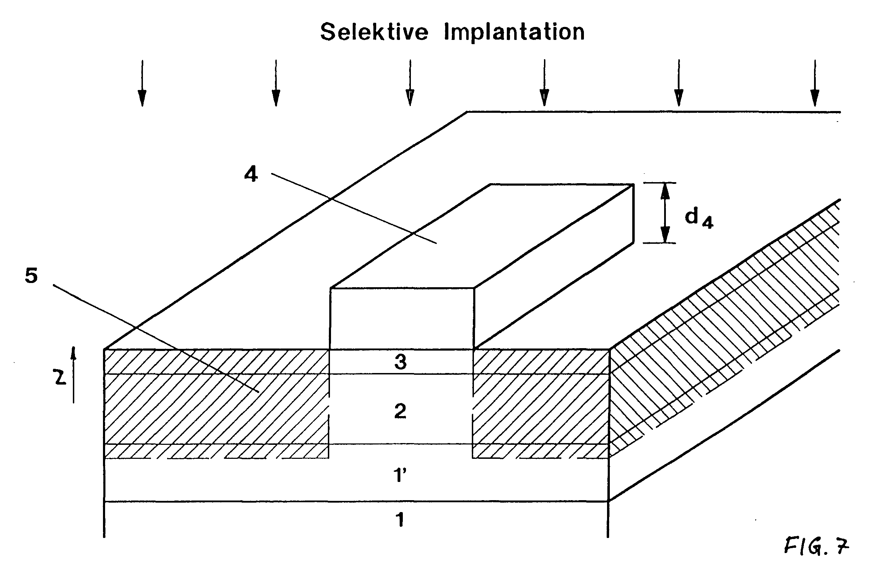

Für die Herstellung von planaren und integrierbaren Metall-Halbleiter-Dioden wird ein einfaches Herstellungsverfahren vorgeschlagen. In FIG. 7 ist die mit einem Epitaxieverfahren, vorzugsweise Molekularstrahlepitaxie, hergestellte Halbleiterscheibe perspektivisch im Schnitt dargestellt, wobei von den epitaktisch auf dem halbisolierenden GaAs-Substrat 1 abgeschiedenen Schichten nur die Schichten 2 und 3 dotiert und leitfähig sind (siehe auch FIG. 1). Für die Realisierung einer vollkommen planaren Struktur werden sämtliche, leitfähigen Gebiete außerhalb des für die Metall-Halbleiter-Diode vorgesehenen Bereichs mit Hilfe eines Implantationsverfahrens, vorteilhafterweise mit Bor- oder Sauerstoff-Ionen, wieder isoliert. Der lateral selektive Isolationsprozeß basiert normalerweise auf einem Ladungsträgereinfang durch die bei der Implantation erzeugten Defekte im Halbleiterkristall.

Die Epitaxiescheibe wird dazu vorteilhafterweise mit einer dielektrischen Schicht 4 lokal abgedeckt. Hierfür verwendet man beispielhaft eine abgeschiedene SiO₂-Schicht, deren Dicke so gewählt wird, daß sie die während des Implantationsprozeß auftreffenden Ionen vollständig absorbiert. Für eine beispielhafte, zu implantierende Schichtdicke von d2 + d3 = 0,7 µm ist dafür eine Dicke d4 < 2 µm ausreichend. Diese dielektrische Kappe 4 in FIG. 7 wird durch photolithographische Verfahren und einem anschließenden Ätzprozeß, vorteilhafterweise mit einer trockenchemischen Technik, strukturiert.
Die Implantation wird vorteilhafterweise mit Bor-Ionen durchgeführt, wobei die Energien und die Dosen auf die zu isolierenden Bereiche und die Dotierkonzentrationen in den Schichten 2 und 3 abgestimmt sind. Für eine beispielhafte, zu implantierende Schichtdicke von d2 + d3 = 0,7 µm mit den im Ausführungsbeispiel vorgeschlagenen Dotierkonzentrationen sind dafür insgesamt zwei bis drei verschiedene Ionenenergien ausreichend. Bei Verwendung von Bor-Ionen sind maximale Energien bis 320 keV für einfach geladene Ionen (B+) mit einer Gesamtdosis von typischerweise <3x10¹³cm⁻² ausreichend, z.B. 320 keV (2x10¹³cm⁻²), 160 keV (6x10¹²cm⁻²) und 80 keV (2x10¹²cm⁻²). Bei Verwendung von Sauerstoff-Ionen sind maximale Energien bis typischerweise 450 keV für einfach geladene Ionen (0+) mit einer Gesamtdosis von typischerweise <2x10¹³cm⁻² ausreichend, beispielsweise 450 keV (1x10¹³cm⁻²), 220 keV (3x10¹²cm⁻²) und 110 keV (1x10¹²cm⁻²) Die durch die Implantation elektrisch isolierten Bereiche 5 sind in FIG. 7 schraffiert dargestellt. Das Gebiet unterhalb der Kappe 4 ist für das Bauelement vorgesehen und in seinen elektrischen Eigenschaften durch die Implantation nicht beeinflußt.

Falls die planare Halbleiterdiodenanordnung für besondere Anwendungsfälle thermisch besonders stabil sein soll, beispielsweise für einen weiteren epitaktischen Überwachstumsprozeß zum Zweck der Abscheidung zusätzlicher Schichten für eine monolithische Integration additiver Bauelemente, wird vorteilhafterweise das zu isolierende Gebiet mit Sauerstoff-Ionen hoher Gesamtdosis im Bereich von 2x10¹⁵cm⁻² implantiert, mit Energien bis max. 440 keV für das Ausführungsbeispiel von d2 + d3 = 0,7 µm, beispielsweise 440 keV (9x10¹⁴cm⁻²), 210 keV (7x10¹⁴cm⁻²) und 100 keV (2x10¹⁴cm⁻²). Anschließend ist ein Ausheilschritt bei Temperaturen im Bereich von 700 C durchzuführen, wobei die Halbleiteroberfläche bei diesem Prozeßschritt vorteilhafterweise durch eine dielektrische Schicht, beispielsweise mit SiON, abgedeckt wird, um einer Oberflächendegradation vorzubeugen. Es ist aus H. Müssig, H. Brugger, und A. Forchel, Proceedings of the 20th International Symposium on Galliumarsenide and Related Compounds, Freiburg (Germany), Aug. 29 - Sept. 2, 1993, bekannt, daß in diesem Fall die Isolationswirkung durch eine chemisch-induzierte Kompensation der Ladungsträger stattfindet, mit dem Vorteil, daß die Isolationswirkung bis zu hohen Temperaturen stabil bleibt, insb. bis zu den üblichen Epitaxietemperaturen.

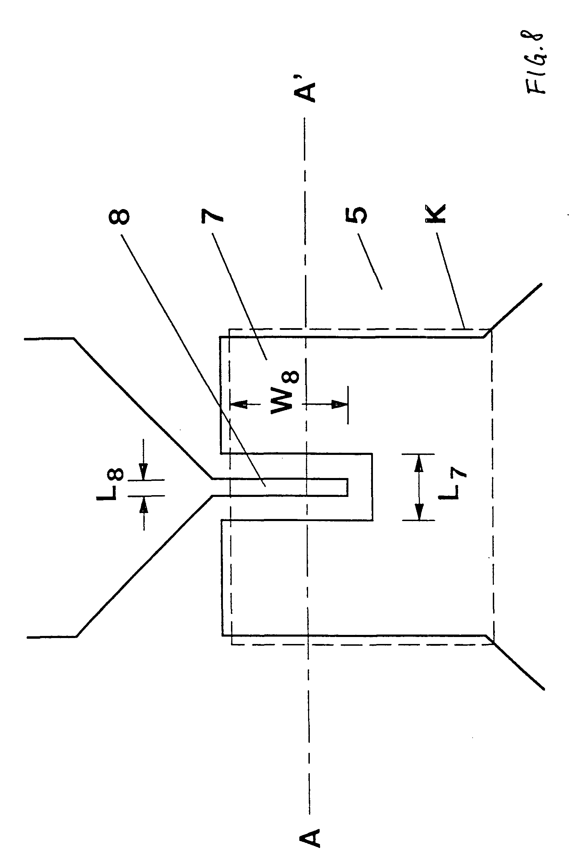

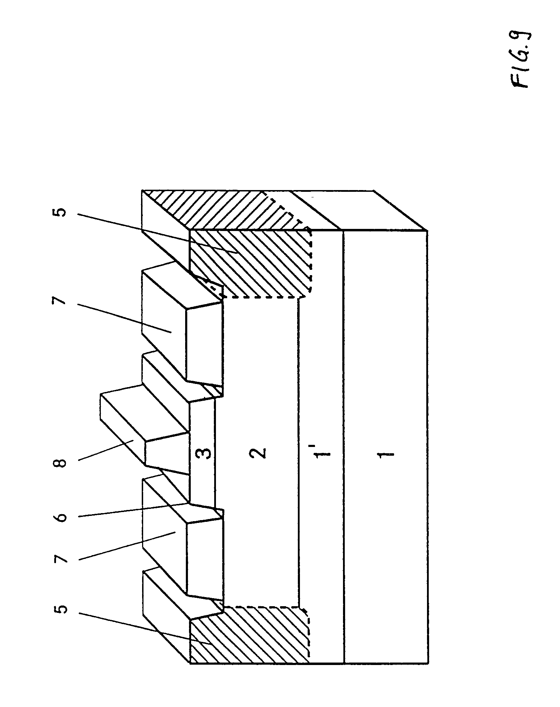

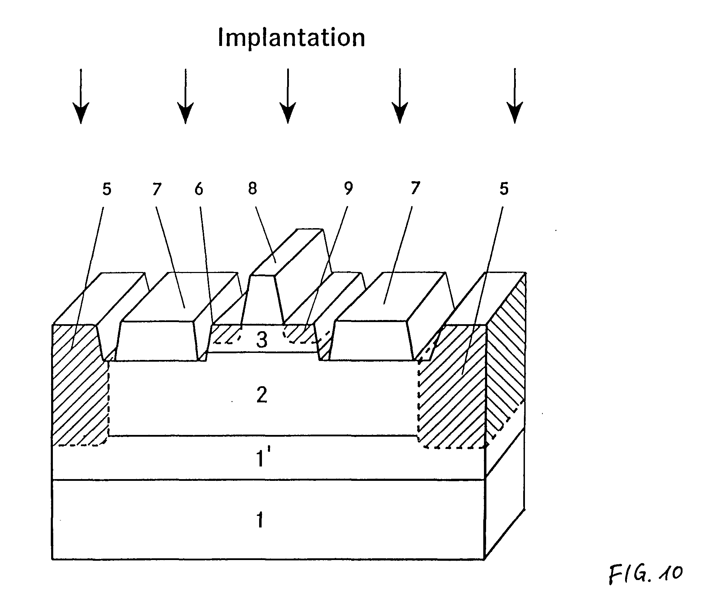

Die Kontaktmetallisierungsanordnung und laterale Bauelementanordnung ist in FIG. 8 dargestellt. Der gestrichelt dargestellte, nahezu quadratisch erscheinende Bereich K kennzeichnet das während der Implantation durch die Kappe 4 abgedeckte Gebiet zwischen isoliertem Bereich (außerhalb) und dem Bauelementgebiet (innerhalb). Der Schottky-Metallkontakt 8 ist vorteilhafterweise als Finger ausgebildet und besteht beispielsweise aus einer allgemein bekannten Pt/Ti/Au-Schichtenfolge. Die effektive, stromführende Fläche ist durch die Fingerweite W8 und -länge L8 festgelegt. Die elektrisch aktive Weite W8 wird vorderseitig durch das Metallisierungsende und rückseitig durch die Implantationsgrenze (dargestellt durch die gestrichelte Linie) definiert. Der ohmsche Kontaktbereich 7 ist vorzugsweise U-förmig um den Schottky-Metallkontakt 8 mit einer Abstandsöffnung L7 angebracht und besteht beispielsweise aus einer allgemein bekannten Ge/Ni/Au-Legierung. Die vorgeschlagene, vorteilhafte vertikale Bauelementanordnung ist in FIG. 9 perspektivisch dargestellt. Die Abbildung entspricht einem Schnitt enlang AA' in FIG. 8. Wichtig dabei ist, daß der Schottky-Metallkontakt 8 auf der Epitaxieoberfläche liegt, die erfahrungsgemäß eine hohe Qualität besitzt. Vorteilhaft ist auch, daß sich die ohmschen Metallkontakte 7 direkt auf der niederohmigen (< 10 Ω/sq) Zuleitungsschicht 2 befinden. Zur Herstellung des ohmschen Kontaktbereichs 7 werden mittels eines photolithographischen Verfahrens und eines Ätzverfahrens innerhalb des nicht implantierten Bauelementgebiets K (siehe FIG. 8) entsprechende Öffnungen hergestellt und die ohmschen Kontakte aufgebracht. Diese sind um mindestens die Verarmungszonenlänge d3 von in diesem Ausführungsbeispiel typischerweise 50 nm bis 100 nm gegenüber der Epitaxieoberfläche und dem Schottky-Metallkontakt abgesenkt. Diese geringe Höhendifferenz ist vollkommen unkritisch für die lithographischen Strukturierungsverfahren. Gleichzeitig entsteht bei diesem Strukturierungsvorgang vorteilhafterweise eine Mesastruktur 6. Die schraffierten Bereiche 5 in FIG. 9 kennzeichnen die durch Implantation isolierenden Bereiche außerhalb des Bauelementgebiets (siehe auch FIG. 7). Messungen haben ergeben, daß die mit diesem Implantationsverfahren erreichbaren, spezifischen Isolationswiderstandswerte in vormals bis zu 10¹⁹cm⁻³ n-dotierten und typischerweise zwischen 0,4 µm und 0,8 µm dicken GaAs-Bereichen über 10⁷ Ωcm sind. Dies entspricht mindestens den Werten, die für kommerziell erhältliche, halbisolierende GaAs-Halbleiterscheiben spezifiziert sind und in der Millimetertechnik bevorzugt angewendet werden. Die Metallisierungsleitungen außerhalb des Bauelementbereichs K liegen deshalb besonders HF-verlustarm auf den mittels Isolationsimplantation erzeugten, hoch resistiven Epitaxieschichten.
Die vorgeschlagene Anordnung ermöglicht die Realisierung von Bauelementen mit sehr kleinen, parasitären Kapazitäten von unter 3 fF, wie z.B. Messungen an Strukturen mit Schottky-Metallkontakten 8 mit W8 x L8 = 5 µm x 2 µm und einer ohmschen Kontaktabstandsöffnungen L7 von 5 µm über HF-Transmissionsmessungen und Anpassung an die Streuparameterkurven ergeben haben. Außerdem gewährleistet die vorgeschlagene Anordnung eine vorteilhafte Minimierung der Bahnwiderstandskomponenten, die einen wesentlichen Beitrag zum Serienwiderstand Rs beitragen. Ferner wird die Durchbruchscharakteristik in Sperrichtung günstig.
Eine weitere, vorteilhafte und einfach zu realisierende Ausgestaltung der Anordnung von FIG. 9 ist in FIG. 10 gezeigt. In die fertige Bauelementstruktur läßt sich ohne jegliche Maskierung durch eine weiche Implantation mit Bor- oder Sauerstoffionen geringer Dosis und geringer Energie, beispielsweise 30 keV, auf einfache Weise ein isolierendes Gebiet 9 in der Mesastruktur zwischen dem Schottky-Metallkontakt 8 und den Ohmschen Kontakten 7 erzeugen. Dadurch wird eine vorteilhafte Stromführung unterhalb des Schottky-Metallkontakt erzeugt und eventuelle Leckströme auf der Mesaoberfläche reduziert.
Zum Schutz der Bauelementanordnung vor Umwelteinflüssen kann die fertige Struktu abschließend passiviert werden, beispielsweise mit an sich bekannten dielektrischen Beschichtungen.

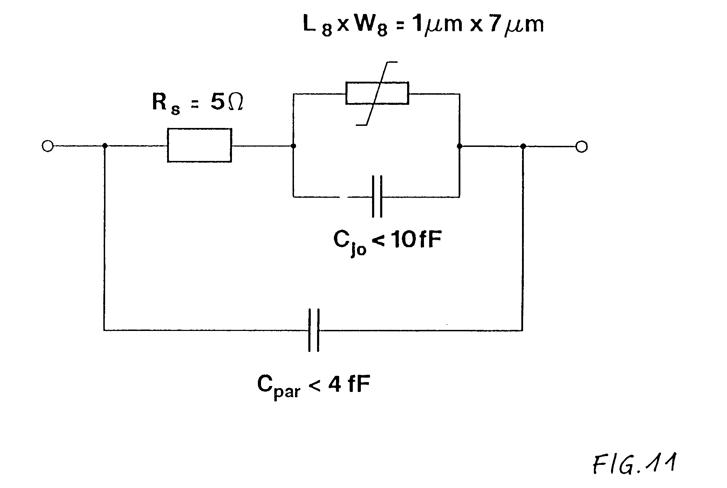

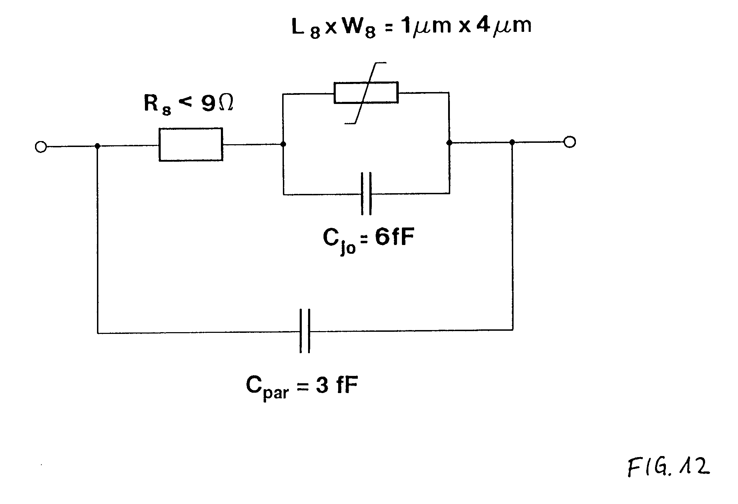

Mit der vorgeschlagenen Anordnung lassen sich Metall-Halbleiter-Dioden herstellen, die vorteilhafte, niedrige Ersatzschaltbildgrößen für Millimeterwellenanwendungen aufweisen. In FIG. 11 sind typischerweise erreichbare Größen für Rs, Cj0 und Cpar für eine beispielhafte Schottky-Kontaktgeometrie von 1 µm x 7 µm dargestellt. Derartige Strukturgrößen lassen sich noch mit lichtoptischen Lithographieverfahren herstellen. Mit der vorgeschlagenen Anordnung und dem vorteilhaften Herstellungsverfahren lassen sich Metall-Halbleiter-Dioden mit "Cut-off" Frequenzen fco im Bereich 2 THz bis 3 THz herstellen. Durch Einsatz von einer Steppertechnologie lassen sich problemlos Strukturgrößen bis 0,5 µm erreichen. Damit sind noch höhere fco-Werte realisierbar. Je nach Anwendungszweck, z.B. für Detektoren, kann eine niedrigere Kapazität vorteilhafter sein als ein extrem niedriger Serienwiderstand. Durch entsprechende Verkürzung des Schottky-Metall-Kontakts lassen sich deutlich niedrigere Cj0-Werte erreichen, wie in FIG. 12 dargestellt ist.

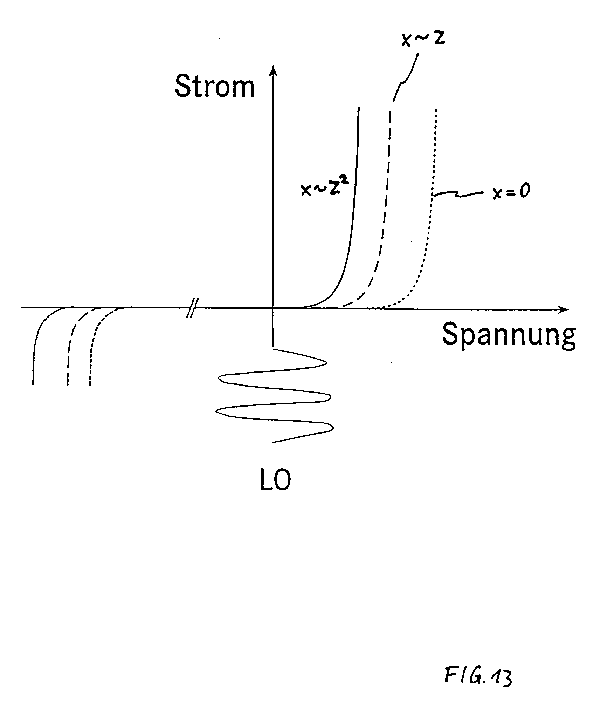

Speziell für Mischeranwendungen läßt sich durch die vorgeschlagene Schichtstruktur mit nichtlinear ansteigender In-Konzentration in der Verarmungszone besonders effektiv die Einsatzspannung reduzieren, wie dies zusammenfassend nochmals in FIG. 13 dargestellt ist. Dies führt zusammen mit der vorteilhaften Bauelementanordnung für sehr niedrige Serienwiderstands- und Kapazitätswerte zu Mischerdioden mit deutlich geringerem LO-Leistungsbedarf als bei Dioden mit GaAs-Verarmungszonen. Vorallem ist die Kombination aus der Bauelementanordnung und dem Verfahren besonders vorteilhaft für die Herstellung von planaren Strukturen, da es kostengünstig und technologisch einfach ist.

Die vorgeschlagene planare Bauelementanordnung und das Verfahren zu deren Herstellung sind auch auf andere vertikal geschichtete Dioden-Strukturen mit vergrabenen und zu kontaktierenden Schichten anwendbar und nicht auf die beispielhaft angegebenen Metall-Halbleiter-Dioden beschränkt.

Ferner können zusätzlich eine dünne (z.B. 2 nm) Ätzstop-Schicht (z.B. AlAs oder Al_{y}Ga_{1-y}As) und/oder eine GaAs Passivierungschicht (z.B. 10 nm)auf der Verarmungszonenschicht aufgewachsen werden, um deren Oberfläche bei nachfolgenden Verarbeitungsschritten besser zu schützen. Diese zusätzlichen Schichten lassen sich dann vor dem Aufbringen der Kontaktmetallisierungen, zumindest in deren Oberflächenbereichen, wieder leicht abtragen durch Verwendung bekannter selektiver Ätzverfahren

## Patentansprüche

1. Metall-Halbleiter-Diode in planarer Anordnung, worin,
- die Diode eine hochdotierte Zuleitungsschicht, eine darauf abgeschiedene Verarmungszonenschicht und die Diode umgebende, durch die Zuleitungsschicht und die Verarmungszonenschicht reichende Isolationsgebiete enthält,
- auf der Oberfläche der Verarmungszonenschicht ein Metall-Kontakt angeordnet ist,
- durch die Verarmungszonenschicht in die Zuleitungsschicht reichende Öffnungen mit Anschlußkontakten eingebracht sind,
- der Metall-Kontakt auf einer Verarmungszone aus verspanntem Inₓ Ga₁₋ₓ As aufgebracht ist, und
- der Indium-Gehalt (x) innerhalb der Verarmungszone in Richtung des Metall-Kontakts kontinuierlich zunimmt.

2. Diode nach Anspruch 1, **dadurch gekennzeichnet, daß** der Verlauf des Indium-Gehalts einer Funktion höherer Ordnung folgt.

3. Diode nach Anspruch 1 oder 2, **dadurch gekennzeichnet, daß** die Verarmungszone auf einer hochdotierten GaAs Zuleitungsschicht gitterangepaßt aufgewachsen ist.

4. Diode nach einem der Ansprüche 1 bis 3, **dadurch gekennzeichnet, daß** die Verarmungszonenschicht ein Dotierprofil mit ortsabhängigem Konzentrationsverlauf aufweist.

5. Diode nach Anspruch 1, **gekennzeichnet durch** Isolationgsgebiete seitlich des Metall-Kontakts an der Grenze der Verarmungsschicht zu den Öffnungen.

6. Verfahren zur Herstellung einer Metall-Halbleiter-Di-ode nach Anspruch 1, mit folgenden Merkmalen
- auf eine hochdotierte Zuleitungsschicht wird in einem einheitlichen Epitaxieschritt mit im Zeitverlauf zunehmendem Indium-Gehalt eine InₓGa₁₋ₓAs-Verarmungszonenschicht aufgewachsen.
- mittels eines Implantationsverfahrens werden einem vorgesehenen Diodenbereich umgebende Isolationsgebiete durch die Verarmungszonenschicht und die Zuleitungsschicht erzeugt
- auf der Verarmungszonenschicht werden im Diodenbereich ein Dioden-Metall-Kontakt und über den Isolationgsgebieten Zuleitungen hergestellt
- im Diodenbereich werden durch die Verarmungszonenschicht Gräben zur Kontaktierung der Zuleitungsschicht erzeugt.

7. Verfahren nach Anspruch 6, **dadurch gekennzeichnet, daß** unter Verwendung des Dioden-Metall-Kontakts mittels eines Implantationsverfahrens diesen umgebende Isolationsgebiete in der Verarmungszonenschicht erzeugt werden.

8. Verfahren nach Anspruch 6 oder 7, **dadurch gekennzeichnet, daß** auf der Verarmungszonenschicht zusätzlich eine Ätzstop-Schicht und oder eine Passivierungs-Schicht abgeschieden werden.

## Claims

1. Metal-semiconductor diode in a planar arrangement, wherein
- the diode contains a highly doped lead layer, a depletion zone layer deposited thereon, and insulation regions which surround the diode and extend through the lead layer and the depletion zone layer,
- a metal contact is arranged on the surface of the depletion zone layer,
- openings extending through the depletion zone layer into the lead layer are introduced, with connection contacts,
- the metal contact is applied on a depletion zone made of strained InₓGa₁₋ₓAs, and
- the indium content (x) within the depletion zone increases continuously in the direction of the metal contact.

2. Diode according to Claim 1, **characterized in that** the profile of the indium content follows a higher-order function.

3. Diode according to Claim 1 or 2, **characterized in that** the depletion zone is grown in a lattice-matched manner on a highly doped GaAs lead layer.

4. Diode according to one of Claims 1 to 3, **characterized in that** the depletion zone layer has a doping profile with a location-dependent concentration profile.

5. Diode according to Claim 1, **characterized by** insulation regions laterally with respect to the metal contact at the boundary between the depletion layer and the openings.

6. Method for producing a metal-semiconductor diode according to Claim 1, having the following features
- an InₓGa₁₋ₓAs depletion zone layer is grown on a highly doped lead layer in a uniform epitaxy step with the indium content increasing over the course of time
- insulation regions through the depletion zone layer and the lead layer, the said regions surrounding a diode region provided, are produced by means of an implantation method
- on the depletion zone layer, in the diode region, a diode-metal contact and, above the insulation regions, leads are produced
- in the diode region, trenches for making contact with the lead layer are produced through the depletion zone layer.

7. Method according to Claim 6, **characterized in that**, using the diode-metal contact, insulation regions surrounding the latter are produced in the depletion zone layer by means of an implantation method.

8. Method according to Claim 6 or 7, **characterized in that** an etching stop layer and/or a passivation layer are additionally deposited on the depletion zone layer.

## Revendications

1. Diode à contact métal-semiconducteur en arrangement plan, où
- la diode comprend une couche d'alimentation, une couche de zones d'appauvrissement précipitée sur celle-ci et une région d'isolation entourant la diode et s'étendant à travers la couche d'alimentation et la couche de zones d'appauvrissement,
- un contact métallique est disposé sur la surface de la couche de zones d'appauvrissement,
- des orifices avec des contacts de raccordement sont intégrés à travers la couche de zones d'appauvrissement et pénètrent dans la couche d'alimentation,
- le contact métallique est appliqué sur une zone d'appauvrissement en InₓGa₁₋ₓAs déformée, et
- la teneur en indium (x) à l'intérieur de la zone d'appauvrissement augmente continuellement en direction du contact métallique.

2. Diode selon la revendication 1, **caractérisée en ce que** la courbe de teneur en indium suit une fonction d'ordre supérieur.

3. Diode selon la revendication 1 ou 2, **caractérisée en ce que** la zone d'appauvrissement est précipitée sur une couche d'alimentation en GaAs fortement dopée au réseau cristallin adapté.

4. Diode selon l'une des revendications 1 à 3, **caractérisée en ce que** la couche de zones d'appauvrissement présente un profil de dopage avec un tracé de la concentration dépendant du lieu.

5. Diode selon la revendication 1, **caractérisée par** des régions d'isolation à côté du contact métallique à la limite de la couche d'appauvrissement vers les orifices.

6. Procédé pour fabriquer une diode à contact métal-semiconducteur selon la revendication 1 avec les caractéristiques suivantes
- une couche de zones d'appauvrissement en InₓGa₁₋ₓAs est précipitée sur une couche d'alimentation fortement dopée dans une étape d'épitaxie homogène avec une teneur en indium croissante dans le temps,
- des régions d'isolation entourant une zone prévue de la diode sont produites au moyen d'un procédé d'implantation à travers la couche de 'zones d'appauvrissement et la couche d'alimentation,
- un contact métallique de diode est réalisé sur la couche de zones d'appauvrissement dans la zone de la diode et des lignes d'alimentation au-dessus des régions d'isolation,
- des fossés sont produits à travers la couche de zones d'appauvrissement dans la zone de la diode pour établir le contact avec la couche d'alimentation.

7. Procédé selon la revendication 6, **caractérisé en ce que** des régions d'isolation entourant le contact métallique de la diode sont produites dans la couche de zones d'appauvrissement en utilisant le contact métallique de la diode au moyen d'un procédé d'implantation.

8. Procédé selon la revendication 6 ou 7, **caractérisé en ce qu'**une couche d'arrêt de gravure et/ou une couche de passivation sont en plus précipitées sur la couche de zones d'appauvrissement.
